(19) 

Europäisches
Patentamt
European
Patent Office
Office européen
des brevets

(11) **EP 1 837 914 A2**

(12) **EUROPEAN PATENT APPLICATION**

(43) Date of publication:
**26.09.2007 Bulletin 2007/39**

(51) Int Cl.:
***H01L 27/32*** *(2006.01)*

(21) Application number: **07251216.3**

(22) Date of filing: **22.03.2007**

| | |
|---|---|
| (84) Designated Contracting States:<br>**AT BE BG CH CY CZ DE DK EE ES FI FR GB GR HU IE IS IT LI LT LU LV MC MT NL PL PT RO SE SI SK TR**<br>Designated Extension States:<br>**AL BA HR MK YU** | (72) Inventors:<br>• **Keiichiro Hayakawa**<br> **Tokyo 2 - 33 - 19 (JP)**<br>• **Masakatsu Kuroki**<br> **Kanawasaki-shi ,Kanagawa 211 - 0041 (JP)** |
| (30) Priority: **22.03.2006 US 784719 P**<br> **19.03.2007 US** | (74) Representative: **Towler, Philip Dean**<br> **Frank B. Dehn & Co.**<br> **St Bride's House**<br> **10 Salisbury Square**<br> **London EC4Y 8JD (GB)** |
| (71) Applicant: **E.I. du Pont de Nemours and Company**<br> **Wilmington, DE 19898 (US)** | |

(54) **Dielectric, display equipped with dielectric, and method for manufacturing said dielectric**

(57) The present invention provides a dielectric used in a display device. The dielectric has a lower dielectric layer composed of a photosensitive composition and an upper dielectric layer, composed of a photosensitive composition formed on the above-mentioned lower dielectric layer, are included, with the transmittance of the above-mentioned upper dielectric layer to light used in a certain pattern exposure being lower than the transmittance of the above-mentioned lower dielectric layer to the light used in said pattern exposure.

EP 1 837 914 A2

**Description**

## TECHNICAL FIELD

The present invention pertains to a dielectric used in a display device (display). More specifically, the present invention pertains to a dielectric arranged in the light emitting part in a display. The present invention also pertains to a display equipped with the dielectric and a method for manufacturing the dielectric.

## TECHNICAL BACKGROUND

Various types of flat panel displays have been developed. In the different types of displays, light emission is controlled by applying a voltage to electrodes and turning the electrodes on and off. For example, in a field emitter display (FED), electrons discharged from a field emitter are supplied to a fluorescent material, so that light is emitted. Light emission is controlled by turning the electrodes on and off. Dielectrics (insulators) are arranged in the vicinity of each electrode for various purposes. For example, an insulating material may be arranged between the electroconductive parts to insulate them. Also, insulating material may be arranged to partition the electrodes.

The dielectric and the insulator are sometimes designated as either "dielectric" or "insulator" in accordance with the arrangement position and their purpose, even if they have the same composition. For this reason, the insulating material arranged in the vicinity of the electrodes is called "dielectric." However, the following technical range is not limited by this usage. The term "dielectric" in the following technique includes "dielectric" or "insulator", or both of them. The dielectric material may be a glass powder or an inorganic filler. As a method for forming a dielectric pattern, pattern printing or etching using a photoresist has been used. However, in pattern printing, a fine pattern is difficult to form. Also, in the etching process using a photoresist, the etching object is frequently limited to a thin film. Where it is necessary for an insulating material arranged between electroconductive parts to be a thick film, etching using a photoresist is not appropriate for such an application. Accordingly, in order to form an insulator of a thick film, a technique for forming a fine pattern using a photosensitive insulator paste has been developed.

As the insulator paste, there are glass pastes and inorganic pastes. However, in the manufacture of displays, backing substrates are mostly glass substrates, and the firing temperature is typically limited to 600°C or lower, preferably 550°C or lower. In this case, if the inorganic filler is included, sintering is suppressed, so that a dense dielectric is difficult to obtain. Accordingly, in the process for manufacturing a display, a paste mainly composed of glass is preferably used.

Various techniques for forming fine patterns by using a photosensitive insulator paste to form an insulator of a thick film have been used. Japanese Kokai Patent Application No. Hei 8[1996]-50811, describes a photosensitive insulating glass paste used for a plasma display panel containing a glass powder, an acrylic copolymer having a carboxyl group and an ethylenically unsaturated group and the side chain or at the molecular terminal is presented. In forming a dielectric pattern by using the photosensitive insulating glass paste, first, the glass plate is spread on a substrate, and the solvent is vaporized by drying. Next, a prescribed pattern is exposed using a photomask. With said exposure, an organic photosensitive binder of the exposed part is crosslinked and polymerized, so that it is not exposed. The unexposed part is developed using an alkali, so that a non-fired dielectric with a desired pattern is obtained. A dielectric is then obtained by firing it at a desired temperature. However, in this publication, the so-called "undercut" is not prevented and does not result in a thick film type of dielectric with an excellent precision of the desired fine pattern.

In Japanese Kokai Patent Application No. 2004-318116, a glass powder type of photosensitive paste that includes oxide particulates with a particle diameter of 0.005-0.08 $\mu$m, inorganic particles other than the oxide particulates, and a photosensitive organic component, and in which the average refractive index N1 of the oxide particulates and the organic component, and the average refractive index N2 of the inorganic particles other than the oxide particulates, satisfy the following relation.

$$- 0.07 \leq N2 - N1 \leq 0.07 \ (N2 > 1.65)$$

However, in this publication, no thick film type of dielectric with excellent precision of the desired fine pattern is presented at all.

As such a glass powder type of photosensitive paste, a glass containing lead has been used; along with the increased consciousness regarding environmental protection on a global scale, it has been desirable to avoid a lead-containing glass to the extent possible. On the other hand, in a dielectric using the lead-free glass, it is difficult in practice to exert characteristics (for example, the precision of the above-mentioned fine pattern) equivalent to or higher than those of a dielectrics using the lead containing glasses.

Furthermore, in the case where a thick film of one layer is formed, since a sufficient light irradiation was sometimes not realized at the lowermost part of the thick film, a considerable amount of exposure was required, and the productivity was low.

## SUMMARY OF THE INVENTION

The present invention concerns a dielectric comprising an upper dielectric layer formed on a lower dielectric layer, characterized by the fact that the lower dielectric layer is comprised of a first photosensitive composition, and the upper dielectric layer is comprised of a second photosensitive composition, wherein the transmittance of light through the upper dielectric layer used to create a desired pattern of exposure is lower than the transmittance of light through the lower dielectric layer. In the above dielectric, the first photosensitive composition is comprised of a first glass powder and the second photosensitive composition is comprised of a second glass powder,

A further embodiment of the present invention is related to a method for manufacturing a dielectric, comprising the following steps:

providing a lower photosensitive dielectric composition and an upper photosensitive dielectric composition each comprising a glass powder, monomer, initiator, resin binder, and organic solvent;
providing a substrate;
coating said lower photosensitive dielectric composition on said substrate;
drying said lower photosensitive dielectric composition to form a lower dielectric layer;
coating said upper photosensitive dielectric composition on said lower dielectric layer;
drying said upper photosensitive dielectric composition to form an upper dielectric layer;
exposing a prescribed pattern on said lower dielectric layer and said upper dielectric layer;
developing the exposed layers to form developed layers;
firing the developed layers; and

wherein said upper dielectric layer has a lower transmittance of light used in a pattern exposure compared to that of said lower dielectric layer.

## BRIEF DESCRIPTION OF THE FIGURES

Figure 1 is a conceptual diagram showing an undercut being generated when a dielectric is formed on a substrate, and exposed and developed.
Figure 2 is a conceptual diagram showing a contraction in the horizontal direction, being caused when a dielectric is molded on a substrate and fired.
Figure 3 shows an example in which a dielectric with a two-layer structure is formed on a substrate.
Figure 4 shows a device equipped with the dielectric of the present invention.
Figure 5 is a flow chart showing each step in the method for manufacturing the dielectric of the present invention.
Figure 6 shows details of each step shown in Figure 5.
Figure 7 shows the line width a and the space width b defined in the present invention.
Figure 8 shows the line deficiency c and the flow d defined in the present invention.

## DETAILED DESCRIPTION OF THE INVENTION

The invention provides an environmentally favorable thick film type of dielectric with excellent precision of the desired fine pattern. The invention concerns a dielectric configuration in which a lower dielectric layer is comprised of a first photosensitive composition, said first photosensitive composition comprising a first glass powder, and an upper dielectric layer formed on the lower above mentioned lower dielectric layer is comprised of a second photosensitive composition, said second photosensitive composition comprising a second glass powder. The light transmittance of the above-mentioned upper dielectric layer used in a certain pattern exposure is lower than the light transmittance of the above-mentioned lower dielectric layer in said pattern exposure. In the dielectric of the present invention, for example, the light transmittance of a second glass powder used in the above-mentioned upper dielectric layer is lower than the transmittance of a first glass powder used in the above-mentioned lower dielectric layer.

In one preferred embodiment, the above-mentioned lower dielectric layer and/or the above-mentioned upper dielectric layer include(s) only a certain glass as an inorganic component (i.e., the lower and/or upper dielectric layer's only inorganic component is glass(es) (i.e., one or more glass powders).

Also, the light transmittance of the light wave length is used for pattern exposure, of the second glass powder used in the above-mentioned upper dielectric layer is preferably 30% or more but less than 60%, and the light transmittance of the first glass powder used in the above-mentioned lower dielectric layer is preferably 60% or more. With the use of the glass powder having transmittance in this range, a desired fine pattern can be realized with much higher precision. The expression "Transmittance being lower" herein means that a layer or a material transmits less light than another layer or material if compared in the same thickness.

In the dielectric of the present invention, the wavelength of the above-mentioned light is preferably 350 nm - 400 nm, and the glass powder used in the above-mentioned lower dielectric layer and the glass powder used in the upper dielectric layer are preferably bismuth-containing glass powders.

The glass powder used in the above-mentioned lower dielectric layer is preferably a Bi-Al-B-Si-Zn-Ba containing glass powder or Bi-Al-B-Si-Zn-Ca containing glass powder, and the total content of the above-mentioned Bi-Al-B-Si-Zn-Ba containing glass powder and the above-mentioned Bi-Al-B-Si-Zn-Ca containing glass powder is preferably in the range of 40-100 wt% with respect to the total glass powder content of the above-mentioned lower dielectric layer.

The glass powder used in the above-mentioned upper dielectric layer is also preferably a Bi-Al-B-Si-Zn-Ba containing glass powder or Bi-Al-B-Si-Zn-Ca containing glass powder, and the total content of the above-mentioned Bi-Al-B-Si-Zn-Ba containing glass powder and the above-mentioned Bi-Al-B-Si-Zn-Ca containing glass powder is preferably in the range of 40-100 wt% with respect to the total glass powder content of the above-mentioned lower dielectric layer.

It is preferable for the glass powder used in the above-mentioned upper dielectric layer to also include at least one element selected from Fe, V, Ti, Cu, and Co. The light transmittance (transmittance of light) of the glass powder used in the above-mentioned upper dielectric layer is preferably 30% or more but less than 60%, and the light transmittance of the glass powder used in the above-mentioned lower dielectric layer is preferably 60% or more.

In addition, it is preferable for the above-mentioned lower dielectric layer and the above-mentioned upper dielectric layer to be essentially lead-free (i.e., comprise essentially no lead), to be essentially free of filler (i.e., comprise essentially no filler), and/or are essentially free of alkali compounds (i.e., comprise essentially no alkali compounds). The term "essentially free of" allows for some small amount of the component, as a contaminant.

The present invention also includes a display equipped with the above-mentioned dielectric.

The present invention also pertains to a method for manufacturing a dielectric comprising the following steps:

spreading a lower dielectric composition containing a glass powder, monomer, initiator, resin binder, and organic solvent on a substrate;
forming a lower dielectric layer by drying the above-mentioned lower dielectric composition;
spreading an upper dielectric composition, which includes a glass powder, monomer, initiator, resin powder, and organic solvent and has a lower transmittance to light used in a pattern exposure compared to that of the above-mentioned lower dielectric layer, on the above-mentioned lower dielectric layer;
forming an upper dielectric layer by drying the above-mentioned upper dielectric composition;
exposing a prescribed pattern on the above-mentioned lower dielectric layer; and the above-mentioned upper dielectric layer,
developing the exposed coated film; and a step that fires the developed coated film.

Another method for manufacturing a dielectric is provided, comprising the following steps:

providing a lower photosensitive dielectric composition and an upper photosensitive dielectric composition each comprising a glass powder, monomer, initiator, resin binder, and organic solvent;
providing a substrate;
coating said lower photosensitive dielectric composition on said substrate;
drying said lower photosensitive dielectric composition to form lower dielectric layer;
coating upon said lower composition, said upper photosensitive dielectric composition;
drying said upper photosensitive dielectric composition to form an upper dielectric layer;
exposing a prescribed pattern on said lower dielectric layer and said upper dielectric layer;
developing the exposed layers to form developed layers; firing the developed layers; and

wherein said upper dielectric layer has a lower transmittance of light used in a pattern exposure compared to that of said lower dielectric layer.

Where the dielectric is manufactured, as described, since the transmittance to light used in a pattern exposure in the upper layer and the lower layer is different, the so-called "undercut" width can be reduced, so that the precision of the desired fine pattern is excellent. The term "undercut width" herein means the difference in top pattern width and bottom pattern width after development process. As the bottom part of a film is not as polymerized as the top part (surface) of the film at exposure, the bottom part tends to be washed off by development solution, and which results in narrow remaining width of bottom part comparing with top remaining width.

In particular, the dielectric of the present invention is a thick film type of dielectric with excellent precision of the desired fine pattern. Therefore, the dielectric of the present invention is a dielectric that can be appropriately arranged on the light emitting part in a display. In the dielectric of the present invention, on the assumption that it is composed of two upper and lower layers, each of these layers is arranged to have a specific relative transmittance, so as to produce a desired fine pattern.

The glass powder used in the lower dielectric layer and the glass powder used in the upper dielectric layer are preferably bismuth-containing glass powders. With the use of the bismuth-containing glass powder, a desired fine pattern is realized with a higher precision. In the bismuth-containing glass powder, a Bi-Al-B-Si-Zn-Ba glass powder or Bi-Al-B-Si-Zn-Ca glass powder can be used, and the total content of these glass powders is preferably 40-100 wt% with respect to the total glass powder content of the above-mentioned lower dielectric layer.
Furthermore, in case the glass powder used in the above-mentioned upper dielectric layer includes at least one element selected from Fe, V, Ti, Cu, and Co, a desired fine pattern is realized with higher precision.

Furthermore, it is preferable for the above-mentioned lower dielectric layer and the above-mentioned upper dielectric layer to essentially not include lead since it can contribute to environmental pollution on global scale. Also, it is preferable for the above-mentioned lower dielectric layer and the above-mentioned upper dielectric layer to essentially not include a filler since a low-temperature firing is possible and the production efficiency can be improved. In addition, it is preferable for the above-mentioned lower dielectric layer and the above-mentioned upper dielectric layer to essentially not include an alkali compound.

It has been found that if glass with a low transmittance to light used in the exposure was used, various problems resulted. For example, in case a bismuth-containing glass, since the bismuth-containing glass has a low transmittance to light such as i-rays (wavelength: 365 nm) used in the exposure along with a high refractive index, compared with a lead group glass, various problems may result.

If the transmittance to light used in the exposure is low, since a longer time of exposure is required for the proper exposure of a photosensitive composition, the throughput is lowered. Also, if the refractive index is high, similarly, since the quantity of light being scattered is increased, a larger amount of exposure is required. Also, hereinafter, in principle, "transmittance" means "the transmittance to light used in the exposure". Also, if a glass powder with a high refractive index such as bismuth-containing glass is used, it is difficult to form a fine pattern with a high aspect ratio. If the present invention is used, even if a glass powder with a high refractive index such as bismuth-containing glass is used, a fine pattern cannot be formed. For example if a glass with a refractive index of more than 1.7 or a glass with a refractive index of more than 1.8 is used, the present invention is especially effective.

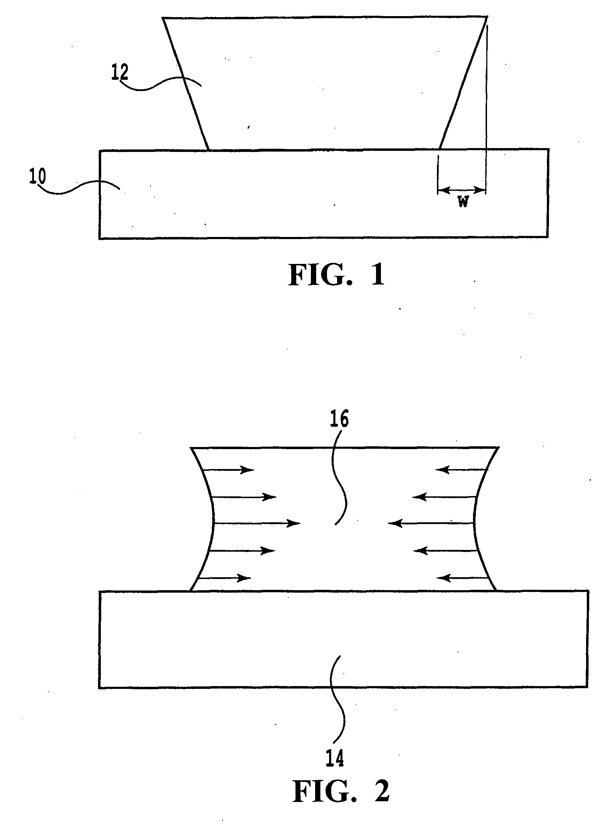

Also, there is a correlation between the transmittance of the dielectric, the undercut, and the pattern contraction. Figure 1 is a conceptual diagram showing an undercut caused when a dielectric 12 is formed on a substrate 10, and exposed. The undercut means that the pattern shape becomes fine toward the lower part of the dielectric 12 as shown in Figure 1. In particular, the part shown by a width W of Figure 1 is called the undercut width, and it is used in the evaluation of the precision of the dielectric 12 in the process for manufacturing said dielectric 12. If the transmittance is low or the refractive index is high, light is scattered until said light reaches the lower part of a photosensitive coated film being exposed, so that the end of the photosensitive part is not sufficiently cured, and the lower part of the dielectric 12 tends to be removed during developing.

Figure 2 is a conceptual diagram showing the contraction in the horizontal direction caused when a dielectric 16 is formed on a substrate 14, and fired. The pattern reduction is caused by the contraction in the horizontal direction caused during firing. As shown in Figure 2, in case firing is applied, since an organic binder is combusted, the contraction to a certain degree cannot be avoided. However, it is desirable for the contraction in the horizontal direction to be as small as possible.

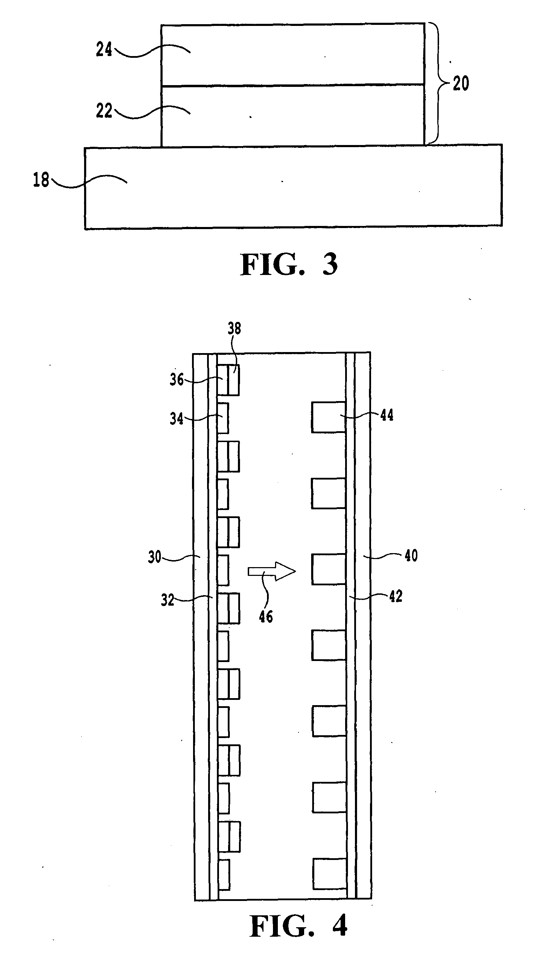

As shown in Figure 3, it was discovered that a dielectric with excellent evaluation qualities could be obtained by forming a dielectric 20 on a substrate 18 by double layer structures 22 and 24 and setting the transmittance of the dielectric layer 24 of the upper part to be lower than the transmittance of the dielectric layer 22 of the lower part. The light transmittance of a glass powder included in the upper dielectric layer 24 was lower than the transmittance of a glass powder included in the lower dielectric layer 22. This embodiment was useful especially for manufacturing the dielectric 20, in Figure 3.

The width W of the above-mentioned undercut can be reduced. The reason for this is that if the dielectric constant of the upper dielectric layer 24 is lower than the dielectric constant of the lower dielectric layer, the upper dielectric layer 24 and the lower dielectric layer 22 can be uniformly exposed and cured, compared with the prior art, and a pattern with an approximately uniform shape can be obtained in the vertical direction of the dielectric 20 as a result of developing.

Also, the shape of the dielectric is easily controlled to a desired size, and the undercut reduction problem of the above-mentioned pattern can be solved. The reason for this is that since the polymerization of the photosensitization is advanced up to the lower dielectric layer 22 while the exposure pattern thickness in the horizontal direction is suppressed by the upper dielectric layer 24 with a low transmittance, the undercut of the unexposed part is reduced when the pattern of the lower dielectric 22 is formed. The method for suppressing the light transmittance of the glass powder used in the dielectric was effective as a method for controlling the transmittance to effectively exert these effects.

The dielectric composition includes: (1) glass powder, (2) monomer, (3) initiator, (4) resin binder, and (5) organic solvent. As (6), other additives (other components), an antioxidant, anti-tackifying agent, UV absorbent, etc., may be included. It is preferable for the dielectric composition to include only the glass component as an inorganic component. When only the glass component is included as an inorganic component, the densification of the fired structure of the powder component due to firing is easily obtained in a relatively low-temperature firing.

(1) Glass powder

The glass powder is not particularly limited; however, it preferably does not contain lead, in consideration of the harmful influence of lead on the environment. For example, a bismuth-containing glass powder, containing essentially no lead is preferable. The reason for this is that the glass design for forming a dense sintered film by melting at a low temperature of about 500-600°C is easy, compared with other non-lead-containing glasses. Also, "containing essentially no lead" is a concept that allows the inclusion of a small amount of lead to be included as a potentially unavoidable impurity. The lead content is preferably 100 ppm or less, more preferably 1 ppm or less. It is most preferable for the lead to not be able to be detected by the currently existing analyzers.

As preferable compositions for the first and/or second glass powder(s), a Bi-Al-B-Si-Zn-Ba containing glass powder or Bi-Al-B-Si-Zn-Ca containing glass can be mentioned. It is preferable to use these bismuth-containing glasses since an amorphous glass is easily obtained at the desired softening point (500°C -600°C). The total content of the Bi-Al-B-Si-Zn-Ba glass or the Bi-Al-B-Si-Zn-Ca glass, in relation to the total glass content of the dielectric layer, is preferably 40-100 wt%. If the total content is 100 wt%, it means that the entire glass powder included consists of the Bi-Al-B-Si-Zn-Ba glass powder or Bi-Al-B-Si-Zn-Ca glass.

If necessary, glass powders with other compositions may also be used. Examples of these other compositions are B-Si, Zn-B-Si, Al-B-Si, Bi-Zn-Si-Al.

It is preferable for the glass included in the upper dielectric layer to contain at least one element selected from Fe, V, Ti, Cu, and Co. If these elements are included, the UV transmittance tends to decrease. Also, the weight based on the oxide weight of these elements is preferably 0.1-2.0 wt% with respect to the total weight of the glass powder.

The transmittance of the upper dielectric layer and the lower dielectric layer can be controlled by the adjustment of the type of monomer and the control of the initiator. When patterning is carried out using a photosensitive composition, the optimal level of the photosensitivity (photo speed) and the developing pattern width is very important. As a method for adjusting such characteristics, the initiator and the monomer component amounts are often adjusted. In addition, it is known that an infinitesimal amount of UV absorbent and dye can be added as an organic component. It was discovered that, when patterning was carried out using the photosensitive dielectric composition, an insufficient insulation was likely to be caused by foaming of the additives themselves during firing of the dielectric. In other words, if the organic component is improved to optimize the photosensitivity and the developing pattern width, there is a possibility that a new problem will be caused. If the glass powder amount is controlled, a new problem called an "insulation inferiority" due to foaming of the organic component is not likely.

The light transmittance of the glass powder included in the upper dielectric layer used in the pattern exposure is preferably 30% or more but less than 60%, more preferably 30-50%. The light transmittance of the glass powder included in the lower dielectric layer used in the pattern exposure is preferably 60% or more, more preferably 75-95%. The wavelength of light used in the pattern exposure is not particularly limited. Said wavelength of light is 350-400 nm, for instance. More specifically, i-rays with a wavelength of 365 nm can be used.

The transmittance of the glass powder does not mean the transmittance in a powder state, but means the transmittance of the glass itself. The transmittance of the glass powder can be evaluated by preparing a fired film containing a glass powder to be measured, and measuring the transmittance of the fired film. In this application, if a significant difference is observed with respect to the transmittance of the glass powder by an analysis means, the numerical value measured by the following method is defined as the transmittance of the glass powder.

Transmittance testing method:

(a) 50 wt% of a Terpineol binder containing 10% ethylcellulose and 50 wt% of glass powder were mixed and kneaded, so that a paste sample was obtained. In case two kinds or more of glass powders are used together, the glass powders are mixed according to the ratio used.
(b) The paste was printed on the exposed side of a soda lime glass substrate with a thickness of 1.3 mm, cut 2 x 3 inches (5.1 x 7.6 cm). The printing conditions were set so that the fired film thickness was about 5 $\mu$m.

(c) Drying was carried out with warm air at 100°C for 20 min.

(d) Using a belt furnace, firing was carried out under a peak temperature of 520°C and holding time of 10 min. The total firing time was set to 1.5 h.

(e) The sample prepared was placed in a spectrophotometer UV2550 made by the Shimadzu Corporation, light with a wavelength of 300-700 nm was continuously irradiated onto it, and the ratio of the quantity of light transmitted through the sample was set as the transmittance (%) for light at different wavelengths. "Transmittance" means the transmittance at the particular wavelength of light used. For example, in case i-rays (365 nm) were used, the transmittance at 365 nm was stated as the transmittance of the glass powder.

(f) According to (a)-(e), the transmittance of the glass powder included in the upper dielectric layer and the transmittance of the glass powder included in the lower dielectric layer are respectively measured under the same measurement conditions and compared.

Thus, the reason why the transmittance of the fired film made of a non-photoconductive paste containing no photosensitive material is compared is that if a photosensitive material, such as an initiator is included, the photosensitive component absorbs a specific wavelength of light, so the transmittance of the glass cannot be precisely measured. Also, the reason why the sintered film is used instead of a dry film is that since the degree of light scattering depends on the paste composition in the dry film, the transmittance is greatly reduced and its scattering is increased. Also, a stable thin film sample is difficult to be obtained when using a film in which the glass powder is pressed.

The control of crystallinity influences the transmittance of the glass powder. If the amorphorism ratio is reduced, the transmittance tends to decrease.

The glass powder is usually included at 50-70 wt% with respect to the total amount of dielectric composition. However, the present invention is not limited to this range.

(2) Monomer

The monomer is polymerized to form a polymer by irradiating light onto the dielectric composition. In the portion where the pattern is exposed, the polymerization of the monomer included in the composition is advanced, and a cured product that is not removed during the developing process is formed.

The type of monomer is not particularly limited. For example, in the present invention, as a photosetting monomer component, a monomer component containing at least one kind of addition-polymerizable ethylenically unsaturated compound having at least one polymerizable ethylene group can be used.

This compound starts the polymer formation due to the existence of a free radical and can carry out a chain expansion and addition polymerization. This monomer compound is in the nongaseous state, that is, it has a boiling point higher than 100°C and has the effect of rendering plasticity to the organic polymeric binder.

Preferable monomers that are usable alone or in combination with other monomers, are selected from the group consisting of t-butyl (meth)acrylate, 1,5-pentanediol di(meth)acrylate, N,N-dimethylaminoethyl (meth)acrylate, ethylene glycol di(meth)acrylate, 1,4-butanediol di(meth)acrylate, diethylene glycol di(meth)acrylate, hexamethylene glycol di(meth)acrylate, 1,3-propanediol di(meth)acrylate, decamethylene glycol di(meth)acrylate, 1,4-cyclohexanediol di(meth)acrylate, 2,2-dimethylolpropane di(meth)acrylate, glycerol di(meth)acrylate, tripropylene glycol di(meth)acrylate, glycerol tri(meth)acrylate, trimethylolpropane tri(meth)acrylate, compounds described in U.S. Patent No. 3,380,381, 2,2-di(p-hydroxyphenyl)-propane di(meth)acrylate, pentaerythritol tetra(meth)acrylate, triethylene glycol diacrylate, polyoxyethyl-1,2-di-(p-hydroxyethyl)propane dimethacrylate, bisphenol A di-[3-(meth)acryloxy-2-hydroxypropyl] ether, bisphenol A di-[2-(meth)acryloxy acryloxy ether] ether, 1,4-butandiol di-(3-methacryloxy-2-hydroxypropyl) ether, triethylene glycol dimethacrylate, polyoxypropyl trimethylolpropane triacrylate, butylene glycol di(meth)acrylate, 1,2,4-butanediol tri(meth)acrylate, 2,2,4-trimethyl-1,3-pentanediol di(meth)acrylate, 1-phenylethylene-1,2-dimethacrylate, diallyl fumarate, styrene, 1,4-benzenediol dimethacrylate, 1,4-diisopropenylbenzene, and 1,3,5-triisopropylpenylbenzene (here, "(meth) acrylate" is an abbreviation indicating both an acrylate and methacrylate).

Useful monomers are ethylenically unsaturated compounds with a molecular weight of at least 300, such as alkylene glycols or polyalkylene glycols like a $C_2$-$C_{15}$ alkylene glycol having 1-10 ether bonds and compounds described in U.S. Patent No. 2,927,022, such as an alkylene or polyalkylene glycol diacrylate prepared from a compound having an addition-polymerizable ethylene bond, especially when it exists as a terminal group.

Other useful monomers are presented in U.S. Patent No. 5,032,490.

As preferable monomers, there are polyoxyethylenated trimethylolpropane tri(meth)acrylate, ethylated pentaerythritol triacrylate, trimethylopropane tri(meth)acrylate, dipentaerythritol monohydroxy pentaacrylate, and 1,10-decanediol dimethacrylate.

As other preferable monomers, there are monohydroxy polycaprolactone monoacrylate, polyethylene glycol diacrylate (with a molecular weight of about 200), and polyethylene glycol dimethacrylate (with a molecular weight of about 400).

The monomer content may be appropriately set in accordance with the type of monomer used. In general, the monomer is included at 2-10 wt% with respect to the total amount of the dielectric composition.

(3) Initiator

The initiator plays the role of initiating the polymerization of the monomer by absorbing light. The type of initiator is not particularly limited. For example, in the present invention, as the optical initiator, in the exposure to chemical rays at a temperature of 185°C or lower, initiators for generating a free radical, although they are thermally inactive, can be used. These optical initiators include substituted or unsubstituted polynuclear quinones as compounds having two intramolecular rings in a conjugated carbon ring group, for example, 9,10-anthraquinone, 2-methylanthraquinone, 2-ethylanthraquinone, 2-t-butylanthraquinone, octamethylanthraquinone, 1,4-naphthoquinone, 9,10-phenanthrenequinone, benzo[a]antraquinone-7,12-dione, 2,3-naphthacene-5,12-dione, 2-methyl-1,4-naphthaquinone, 1,4-dimethylanthraquinone, 2,3-dimethylanthraquinone, 2-phenylanthraquinone, 2,3-diphenylanthraquinone, retenequinone [retinene quinone], 7,8,9,10-tetrahydronaphthacene-5,12-dione, and 1,2,3,4-tetrahydrozo[a]anthracene-7,12-dione are included. Other useful initiators are described in U.S. Patent No. 2,760,863 (however, some of them are thermally active even at a low temperature of 85°C, and there are vicinal ketaldonyl alcohols such as benzoin or pivaloin; acyloin ethers such as methyl and ethyl ethers of benzoin; $\alpha$-methylbenzoin, $\alpha$-allylbenzoin, $\alpha$-phenylbenzoin, thioxanthone and its derivatives, and hydrocarbon-substituted aromatic acyloins containing a hydrogen donor).

As the initiator, optically reducing dyes and reducing agents can be used. They are described in U.S. Patent Nos. 2,850,445, 2,875,047, 3,097,096, 3,074,974, 3,097,097, and 3,145,104. There are also phenazine, oxazine, quinones, for example, 2,4,5-triphenylimidazolyl dimer with a hydrogen donor containing a leuco dye such as Michler's ketone, ethyl Michler's ketone, and benzophenone, and their mixtures (described in U.S. Patent Nos. 3,427,161, 3,479,185, and 3,549,367). Also, sensitizers described in U.S. Patent No. 4,162,162 are useful along with optical initiators and optical inhibitors.

The type of the initiator and its content may be appropriately set in accordance with the monomer used. The content of a general initiator is 0.1-5 wt% with respect to the total amount of the dielectric composition.

(4) Resin binder

The resin binder assists in the formation of a dielectric with a sufficient hardness. A polymer is formed by the polymerization of a monomer, and the hardness of the dielectric formed is secured to some degree. However, the hardness is insufficient in many cases. For this reason, the resin binder is usually added to the dielectric composition. The type of resin binder is not particularly limited. Its polymeric binder, as mentioned above, is an auxiliary constitutional element of the dielectric composition. It is preferable to select one with a high resolution in consideration of its aqueous developing possibility. It is understood that the following binders meet these requirements. In other words, these binders can be (1) a nonacidic comonomer containing a $C_1$-$C_{10}$ alkyl acrylate, $C_1$-$C_{10}$ alkyl methacrylate, styrene, substituted styrene, or their combinations and (2) a copolymer or interpolymer (mixed polymer) prepared from an acidic comonomer containing an ethylenically unsaturated carboxylic acid part, which is at least 15 wt% of the total polymer weight.

The presence of the acidic comonomer component in the composition sometimes acts effectively. The composition can be developed in an aqueous base such as a 0.4 wt% aqueous solution of sodium carbonate due to its acidic functional group. If the acidic comonomer exists at a concentration of less than 15%, the composition will not be completely washed out by the aqueous base. If the acidic comonomer exists at a concentration of more than 30%, the stability of the composition is low under the developing conditions, and only a partial developing is caused in the part for forming an image. As appropriate acidic comonomers, ethylenically unsaturated monocarboxylic acids such as acrylic acid, methacrylic acid, or crotonic acid, ethylenically unsaturated dicarboxylic acids such as fumaric acid, itaconic acid, citraconic acid, vinylsuccinic acid, and maleic acid, their hemiesters, and sometimes their anhydrides and their mixtures are included. Methacryl polymers are more preferable than acrylic polymers since they are cleanly combusted under a low oxygen atmosphere.

If the above-mentioned nonacidic comonomer is the above-mentioned alkyl acrylate or alkyl methacrylate, the nonacidic comonomer preferably constitutes by at least 50 wt%, preferably 70-75 wt%, of the polymeric binder. If the nonacidic comonomer is styrene or unsubstituted styrene, the nonacidic comonomer is preferably an acid anhydride in which 50 wt% is the polymeric binder and the other 50 wt% is a hemiester of maleic anhydride; $\alpha$-methylstyrene is a preferable substituted styrene.

The nonacidic part of the polymeric binder may include about 50 wt% or less of other nonacidic comonomers that substitute the alkyl acrylate, alkyl methacrylate, styrene, or substituted styrene part of the polymer, although it is not preferable. As examples, there are acrylonitrile, vinyl acetate, and acrylamides. However, in this case, since a complete combustion is more difficult, such a monomer is preferably used at an amount of less than about 25 wt% of the total amount of the polymeric binder. The use of a single copolymer or a combination of copolymers as the binder is allowed as long as each of them meets the above-mentioned various standards. In addition to the above-mentioned copolymers, a small amount of other polymeric binders can also be added. As its examples, polyolefins such as polyethylene, polypropylene, polybutylene, polyisobutylene, and ethylene-propylene copolymer, polyethers or a lower alkylene oxide polymer such as polyethylene oxide can be mentioned.

These polymers can be manufactured by the solution polymerization technique that is generally used in the acrylic ester polymerization field.

Typically, the above-mentioned acidic acrylic ester polymer can be manufactured by mixing an $\alpha$- or $\beta$-ethylenically unsaturated acid (acidic comonomer) with one or more copolymerizable vinyl monomers (nonacidic comonomers) in an organic solvent with a relatively low boiling point (75-150°C) to obtain 10-60% monomer mixture solution, polymerizing the obtained monomer by adding a polymerization catalyst, and heating the mixture at normal pressure and at the solvent's reflux temperature. After the polymerization reaction is essentially completed, preferably, the acidic polymer solution generated is cooled to room temperature, the sample is recovered, and the viscosity, the molecular weight, and the acid equivalent of the polymer are measured.

Furthermore, it is preferable for the above-mentioned polymeric binder containing an acid to have a molecular weight of less than 50,000.

The content of the resin binder may be appropriately set in accordance with the type of other components and its amount being mixed. In general, the resin binder is included at 5-20 wt% with respect to the total amount of dielectric composition.

(5) Organic solvent

An organic solvent is included in the dielectric composition. The main purpose of the organic solvent used is to make a dispersed solution of a finely crushed solid of the dielectric composition in a form that can be easily spread on a ceramic or other substrates. Therefore, in the organic medium, first, it is preferable for the solid fraction to be able to be dispersed while maintaining an appropriate stability; secondly, it is preferable for the rheological characteristic of the organic medium to render a good coating characteristic to the dispersed solution.

In the organic medium, as the solvent component, which may also be a solvent mixture, a solvent component in which a polymer or other organic components are completely dissolved in it is selected. The solvent being selected should be inactive (nonreactive) with respect to the other components of the paste composition. The solvent being selected should have a sufficiently high volatility and can be evaporated from the dispersed solution, even by coating at a relatively low temperature under atmospheric pressure; however, the solvent must not be volatile to the degree that the paste on a screen is rapidly dried at ordinary room temperature during the printing process. The solvent being preferably used in the paste composition has a boiling point of lower than 300°C, preferably lower than 250°C, at normal pressure. As such a solvent, one can mention esters of the above-mentioned alcohols such as an aliphatic alcohol, acetic ester, or propionic ester; terpene such as turpentine, $\alpha$- or $\beta$-terpineol, or mixture; esters of ethylene glycol such as ethylene glycol, ethylene glycol monobutyl ether, and butyl Cellosolve acetate; Carbitol esters such as butyl Carbitol, butyl Carbitol acetate, and Carbitol acetate; and other appropriate solvents such as Texanol (2,2,4-trimethyl-1,3-pentanediol monoisobutylate).

The amount of organic solvent being mixed in may be determined in consideration of the viscosity attained when coating of the dielectric composition, the types of other components, and the amount being mixed. In general, the organic solvent is included at 15-40 wt% with respect to the total amount of dielectric composition. With the addition of the organic solvent, a paste-form dielectric composition is usually obtained.

(6) Other additives

In the dielectric composition of the present invention, the following additive components may be used in addition to the above-mentioned components. As other additives, an antioxidant, anti-tackifying agent, UV absorbent, dye, etc., are mentioned. Also, additive components such as a dispersant, stabilizer, plasticizer, peeling-off agent, stripping agent, defoaming agent, and moisturizer known in the corresponding field may be present in the composition. Appropriate substances are generally presented in U.S. Patent No. 5132,490. Their content is not particularly limited. The content may be appropriately determined in accordance with the required performances, the types of other materials, etc. However, in case the organic component is used, as mentioned above, it is preferable to suppress the amount of organic component being added to a low level to prevent an insulation inferiority due to foaming of the additives during firing.

Also, in the present invention, it is preferable to essentially not include a filler in the lower dielectric layer and the upper dielectric layer. If no filler is included, the densification due to melting of the glass is achieved at a lower temperature. Also, "to essentially not include a filler" is a concept that allows the inclusion of a small amount of filler as an avoidable impurity. The filler content is preferably 20 wt% or less, more preferably 5 wt% or less. It is most preferable that any filler is not detectable by the currently existing analyzers, i.e. essentially no filler is present in the lower and/or upper dielectric layer.

Also, in the present invention, it is preferable to essentially not include an alkali compound in the lower dielectric layer and the upper dielectric layer. If no alkali compound is included, the electric reliability is difficult to be damaged. The reason for this is that alkali ions are easily moved, which may cause damages, such as a short circuit. Also, "to essentially not include an alkali compound" is a concept that allows the inclusion of a small amount an alkali compound included, as an avoidable impurity. The alkali compound content is preferably 1 wt% or less, more preferably 0.1 wt% or less. It is most preferable that any alkali compound is not detectable by the currently existing analyzers, i.e. essentially no alkali compound is present in the lower and/or upper dielectric layer.

The present invention includes a display equipped with the above-mentioned dielectric. The display of the present invention can be used as a Field Emission Display (FED). As the structure of the FED, for example, as shown in Figure 4, one can use a laminate in which cathode electrode 32, emitters 34, gate insulating films 36, and gate electrodes 38 are laminated on a glass substrate 30 and a laminate in which an anode electrode 42 and fluorescent materials 44 are laminated on a glass substrate 40 are opposite to each other, with light 46 being supplied to the fluorescent materials 44 from the emitters 34. In this structure, the above-mentioned dielectric of this application, for example, can be arranged as the gate insulating film 36 used to insulate the cathode electrode 32 and the gate electrodes 38. With the use of the above-mentioned dielectric having excellent precision of the desired fine pattern in this display, the durability of the display itself can be improved.

The present invention includes a method for manufacturing the dielectric, comprising a step that spreads a lower dielectric composition containing a glass powder, monomer, initiator, resin binder, and organic solvent on a substrate; a step that forms a lower dielectric layer by drying the above-mentioned lower dielectric composition; a step that spreads an upper dielectric composition, which includes a glass powder, monomer, initiator, resin powder, and organic solvent and has a lower transmittance for light used in a pattern exposure compared to that of the above-mentioned lower dielectric layer, on the above-mentioned lower dielectric layer; a step that forms an upper dielectric layer by drying the above-mentioned upper dielectric composition; a step that exposes a prescribed pattern on the above-mentioned lower dielectric layer and the above-mentioned upper dielectric layer; a step that develops the exposed coated film, and a step that fires the developed coated film.

The manufacturing method of the present invention is explained referring to the figures.

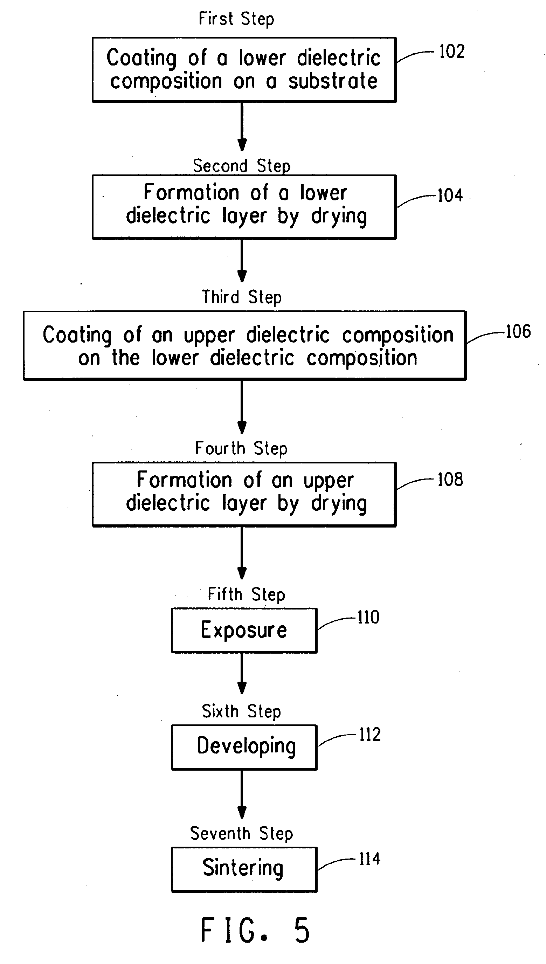

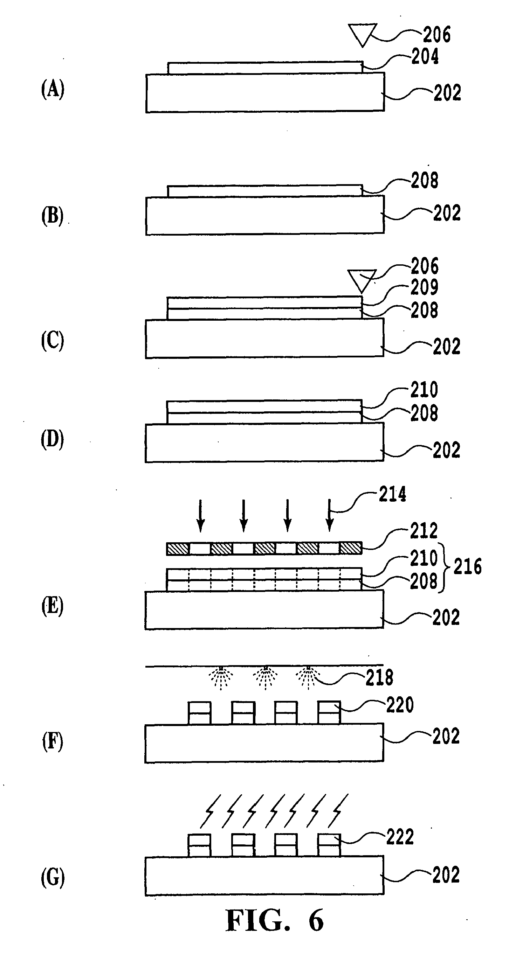

Figure 5 is a flow chart showing each step in the method for manufacturing the dielectric of the present invention; as shown in the figure, said manufacturing method consists of the first step to the seventh step. Also, Figure 6 shows details of each step shown in Figure 5.

The first step is a step that spreads a lower dielectric composition (204) containing a glass powder, monomer, initiator, resin binder, and organic solvent on a substrate (202) (Figure 5: 102, Figure 6(A)). For the coating, the lower dielectric composition (204) is spread on the entire surface of the glass substrate (202) by using a coating means (206) such as entire-surface coating of a screen printing agent and entire-surface coating of a dispenser.

The second step is a step that forms a lower dielectric layer (208) by drying the above-mentioned lower dielectric composition (Figure 5: 104, Figure 6(B)). The drying conditions are not particularly limited as long as the electroconductive composition can be dried; however, the drying may be carried out at 100°C for 10-20 min. Also, the drying can be carried out using a conveyor type of infrared dryer, etc. The thickness of the lower dielectric layer after drying is preferably 10-40 $\mu$m.

The third step is a step that spreads an upper dielectric composition (209), which includes a glass powder, monomer, initiator, resin powder, and organic solvent and has a lower transmittance for light used in a pattern exposure compared to that of the above-mentioned lower dielectric layer, on the above-mentioned lower dielectric layer (208) (Figure 5: 106, Figure 6(C)). As a coating means, the means mentioned at the first step may be used.

The fourth step is a step that forms an upper dielectric layer (210) by drying the above-mentioned upper dielectric composition (Figure 5: 108, Figure 6(D)). As the drying conditions, the conditions mentioned at the second step may be used. The thickness of the upper dielectric layer after drying is preferably 10-40 $\mu$m.

The fifth step is a step that exposes a prescribed pattern on the above-mentioned lower dielectric layer (208) and the above-mentioned upper dielectric layer (210) (Figure 5: 110, Figure 6(E)). In the exposure, a photomask (212) having an electrode pattern is installed on both the dried upper and lower dielectric layers (208, 210), and for example, i-rays (214) are irradiated. The exposure conditions depend on the components of both upper and lower dielectric compositions used, its film thickness, etc., and for example, the exposure is carried out at a level of 100-1,000 mJ/cm$^2$ by using a gap of 50-300 $\mu$m. Thus, an exposed coated film (216) can be obtained.

The sixth step is a step that develops the exposed coated film (Figure 5: 112, Figure 6(F)). The developing is carried out using an-alkali solution. As the alkali solution, for example, a 0.4% aqueous sodium carbonate solution may be used. Such an alkali solution (218) is sprayed on the exposed coated film onto the substrate (202). A developed coated film (220) may be obtained by immersing the substrate (202), having the exposed coated film, into the alkali solution, etc.

The seventh step is a step that fires the coated film developed (Figure 5: 114, Figure 6(G)). The firing can be carried out in a firing furnace having a prescribed temperature profile. The highest temperature during firing is preferably 400-600°C, more preferably 500-600°C. The firing time is preferably 1-3 h. After firing, dielectrics (222) having a desired pattern can be obtained by cooling. The thickness of the lower dielectric layer and the upper dielectric layer after drying is preferably set to 5-20 μm.

According to this manufacturing method, since the transmittance for light used in the pattern exposure is made different in the lower dielectric layer and the upper dielectric layer, the width of a so-called undercut can be reduced, so that a dielectric with the excellent precision of a desired fine pattern can be obtained. In particular, in consideration of environmental protection on a global scale, even if a glass containing no lead is used, the precision of a fine pattern can be favorably obtained. Also, according to said manufacturing method, since the amount of exposure can be decreased by forming a two-layered dielectric layer, the productivity can be improved.

In the manufacturing method of the dielectric of this application, the above-mentioned problems such as "undercut" can be avoided, and the generation of a dielectric breakdown due to pinholes in each dielectric layer after exposing can be further prevented by forming a dielectric consisting of two layers. In case the dielectric with a monolayer structure is formed, if the exposure in part of this layer is insufficient, the part becomes a pinhole, causing an inferiority. For example, in case parts in which the irradiated light does not reach sufficiently due to impurities mixed into the composition, a sufficient curing is not advanced in this part, so that the pattern is likely to flow during developing, or an abnormal contraction or an abnormal foaming is caused by firing, so that an insulation inferiority is likely to be caused. However, in the present invention, since the transmittance of the upper dielectric layer for light used in the pattern exposure is lower than the transmittance of the lower dielectric layer for light used in said pattern exposure, a uniform exposure is realized from the upper part of the upper dielectric layer to the lower part of the lower dielectric layer during exposure, compared with the prior art. For this reason, a sufficient curing is advanced over the entire area of the dielectric, and the generation of pinholes can be suppressed. Furthermore, in the present invention, since the dielectric is formed as two layers, even if pinholes are generated, the possibility that the pinholes generated in both layers are matched in the height direction of the dielectric is very low. For this reason, it can be said that there is no generation of insulation inferiorities, and the dielectric breakdown can be sufficiently prevented.

Also, according to the manufacturing method of the present invention, in addition to these merits, the thickness of the dielectric can be sufficiently secured by forming the dielectric as a two-layer structure.

## EXAMPLES

The present invention is explained in further detail with application examples; however, the following application examples do not intend to limit the present invention. In the following application examples, percentages are based on weight, unless specified otherwise.

## Examples 1 and 2 and Comparative Examples 1-8

In these application examples, UV photosensitive thick film dielectric compositions were used.

(A) Preparation of organic solvent

Texanol (2,2,4-trimethyl-1,3-pentanediol monoisobutyrate) as a solvent and an acrylic polymer binder with a molecular weight of 30,000 were mixed and heated to 100°C while stirring. The heating and stirring were continued until the entire binder polymer was dissolved. The solution obtained was cooled to 75°C; Irgacure 907 and 651 made by Ciba Specialty Chemicals K.K. as a photopolymerization initiator and TAOBN: 1,4,4-trimethyl-2,3-diazabicyclo[3,2,2]-none-2-ene-N,N'-dioxide as a stabilizer were added to it. This mixture was stirred at 75°C until all the solid fractions were dissolved. This solution was passed through a filter of 40 μ and cooled.

(B) Preparation of glass powder

Each component was mixed in compositions shown in Table I, and glass powders were adjusted.

(Table I)

|  | BaO | $B_2O_3$ | $SiO_2$ | $Al_2O_3$ | ZnO | $Bi_2O_3$ | $Fe_2O_3$ |
|---|---|---|---|---|---|---|---|
| Glass powder A | 1 | 9 | 7 | 2 | 8 | 72 | 1 |
| Glass powder B | 1 | 8 | 8 | 2 | 11 | 70 | - |
| Glass powder C | 2 | 18 | 4 | 2 | 8 | 63 | 3 |

The softening point, the average particle diameter, and the transmittance of these glass powders are shown in Table II.

The softening point was measured by differential thermal analysis (DTA).

The transmittance was measured according to the above-mentioned transmittance testing method (processes (a)-(f)).

(Table II)

|  | Softening point | Average particle diameter | Transmittance (%) | | |
|---|---|---|---|---|---|
|  |  |  | 365 nm | 400 nm | 700 nm |
| Glass powder A | 500 °C | 1μm | 25 | 62 | 80 |
| Glass powder B | 510 °C | 1μm | 7 | 42 | 79 |
| Glass powder C | 510 °C | 1μm | 69 | 78 | 79 |

(C) Preparation of photosensitive dielectric composition

Using the above-mentioned glass powders, photosensitive dielectric compositions were prepared. First, the resin binder, monomer, and organic solvent were mixed, so that an organic vehicle was prepared. Next, the organic vehicle was mixed with additives and glass powders. The organic solvent was further added to the mixture to adjust the viscosity, so that paste-shaped dielectric compositions 1-7 were obtained. The components of the dielectric compositions and the amounts are shown in Table III. Also, the compounds used are as follows.

Binder A: 40% Texanol solution of MMA/MAA copolymer with 10% of ITX/Irgacure 651
Binder B: 40% Texanol solution of MMA/MAA copolymer
Monomer A: Ethoxylated trimethylolpropane
Solvent A: Texanol
Additive: 2,6-di-tert-butyl-4-methyl-phenol

(Table III)

| | Composition 1 | Composition 2 | Composition 3 | Composition 4 | Composition 5 | Composition 6 | Composition 7 |
|---|---|---|---|---|---|---|---|
| Binder A (parts by weight) | 6.0 | 6.0 | 6.0 | 6.0 | 6.0 | 6.0 | 6.0 |
| Binder B (parts by weight) | 22.4 | 22.4 | 22.4 | 22.4 | 22.4 | 22.4 | 22.4 |
| Monomer A (parts by weight) | 6.7 | 6.7 | 6.7 | 6.7 | 6.7 | 6.7 | 6.7 |
| Solvent A (parts by weight) | 5.0 | 5.0 | 5.0 | 5.0 | 5.0 | 5.0 | 5.0 |
| Additive (parts by weight) | 0.2 | 0.2 | 0.2 | 0.2 | 0.2 | 0.2 | 0.2 |
| Glass Frit A (parts by weight) | 0.0 | 0.0 | 68.4 | 0.0 | 0.0 | 13.7 | 34.4 |
| Glass Frit B (parts by weight) | 0.0 | 59.7 | 0.0 | 11.9 | 29.9 | 0.0 | 0.0 |
| Glass Frit C (parts by weight) | 65.0 | 0.0 | 0.0 | 52.0 | 32.5 | 52.0 | 32.5 |
| Solvent A (parts by weight) | 3.0 | 3.0 | 3.0 | 3.0 | 3.0 | 3.0 | 3.0 |
| Total amount | 108.3 | 103.0 | 111.7 | 107.2 | 105.7 | 109.0 | 110.2 |
| Glass content (wt%) | 60.0 | 58.0 | 61.2 | 59.6 | 59.0 | 60.3 | 60.7 |
| Transparency 700 nm (%) | 79 | 79 | 80 | 78 | 78 | 79 | 79 |
| Transparency 400 nm (%) | 78 | 42 | 62 | 68 | 58 | 76 | 69 |
| Transparency 365 nm (%) | 69 | 7 | 25 | 42 | 23 | 61 | 45 |

(d) Formation of dielectric

The compositions 1-7 were combined as shown in Tables IV and V, so that dielectrics with a two-layer structure were formed.

A screen mark with a mesh of 150 made of SUS was mounted on a screen printer in a yellow-light-exposed room, and the lower dielectric composition was solid-printed on a soda-containing glass with a thickness of 1.3 mm. After printing, it was dried at 100°C for 20 min by a warm-air drying furnace. The thickness of the dried film obtained was about 20 $\mu$m. The upper dielectric composition was then printed on the dried film by using the same screen mask. After printing, it was similarly dried at 100°C for 30 min with warm air. The dried film thickness of the two-layer dielectric obtained was about 40 $\mu$m.

The dried film was subjected to a pattern exposure via a photomask for evaluating the pattern by using a UV exposure system equipped with a high-pressure mercury lamp, using an emission line of 365 nm. In order to confirm the optimum amount of exposure, each sample was subjected to pattern exposure at different levels of exposure under four conditions, from 20 mJ/cm$^2$ to 640 mJ/cm$^2$.

Separately, when an unexposed dry sample was prepared and developed by an alkali developing processor using a 0.4% aqueous $Na_2O_3$ solution as a developing solution, the time at which the dried film was completely developed was measured (Time To Clear: TTC). The above-mentioned pattern-exposed samples were developed at 1.5 times and 2.5 times with respect to TTC. In other words, for each combination of the lower dielectric composition and the upper dielectric composition, after developing of four exposure conditions x two developing conditions = eight conditions, samples were obtained.

Furthermore, the samples obtained were fired under a firing profile consisting of a peak temperature of 520°C, 20 min, and a total time of 3 hours, using a roller hearth furnace.

For these samples, the following items for the pattern formation of the dielectric were evaluated. Next, conditions that gave good evaluation results were investigated for all of them.

As mentioned above, the problems related to the pattern formation of the dielectric include the undercut and the pattern contraction. For the undercut, the width of the undercut was directly evaluated. Also, the pattern contraction can be evaluated by the evaluation of the line width, the space width, and/or the line deficiency and flow.

Evaluation of line width and space width:

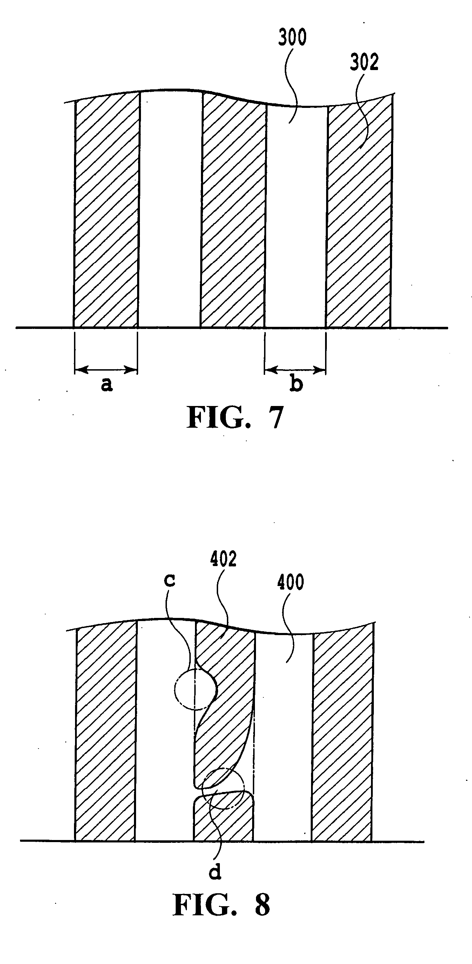

Figure 7 is a plan view showing an embodiment of the pattern shape of a dielectric 302 formed on a substrate 300. In the figure, the width a of slanted parts is defined as the line width, and the width b of the other parts is defined as the space width. In these application examples, using a metallurgical microscope with an XY length measuring function (200 times), the line width (when the dielectric was formed according to an initial design: 100 $\mu$m) and the space width (when the dielectric was formed according to an initial design: 150 $\mu$m) between the lines were measured for the samples after developing. As the evaluation standards, when the line width was in a range of 90-120 $\mu$m, it was evaluated as a success, and when the space width between the lines was in a range of 120-150 $\mu$m, it was evaluated as a success.

Evaluation of line deficiency and flow:

Figure 8 is a plan view showing an embodiment of the pattern shape of a dielectric 402 formed on a substrate 400. Here, in the figure, as shown by a round part c, the deficiency of the dielectric 402 from a desired shape is defined as a line deficiency, and as shown by a round part d, the separation of the dielectric 402 is defined as "flow". In these application examples, the entire formed line pattern quality was observed by a microscope, and the existence of the line deficiency and flow was confirmed. The sample without a line deficiency and flow was evaluated as a success.

Evaluation of undercut:

After observing, the substrate was divided into small segments, and the undercut was evaluated by observing the cross section of the developed film through a SEM. The undercut, as mentioned above, means that the dielectric 12 is narrowed (or widened, although it is not shown in the figure) at the lower side in its perpendicular direction as shown by the part indicated by the width W shown in Figure 1. In the evaluation, in the sectional shape of the dielectric 12 shown in Figure 1, the length of the upper side and the length of the lower side were compared. If the upper side was long, it was shown by a plus sign, and if the lower side was long, it was shown by a minus sign. As the evaluation standards, $\pm$ 10 $\mu$m was evaluated as a success.

The results of the above evaluation items are shown in Tables IV and V. Table IV shows the evaluation results when the developing time was 1.5 times with respect to TTC, and Table V shows the evaluation results when the developing time was 2.5 times with respect to TTC. In Tables IV and V, the evaluation results of the overall decision are placed in the lowermost column. They show overall evaluations of the line width and the space width, the evaluation of the line deficiency and flow, and the evaluation of the undercut.

(Table IV)

| | Amount of exposure, mJ/cm² | Application Example 1 | Application Example 2 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Upper dielectric layer | | Composition 5 | Composition 7 | Composition 1 | Composition 2 | Composition 3 | Composition 4 | Composition 5 | Composition 6 | Composition 7 | Composition 1 |
| Lower dielectric layer | | Composition 1 | Composition 1 | Composition 1 | Composition 2 | Composition 3 | Composition 4 | Composition 5 | Composition 6 | Composition 7 | Composition 1 |
| Transparency 365 nm @10 µm | | 22.6 | 45.2 | 68.6 | 6.5 | 24.6 | 42.4 | 22.6 | 61.2 | 45.2 | 68.6 |
| Developing time (2kgf) x TTC | | 1.5 | 1.5 | 1.5 | 1.5 | 1.5 | 1.5 | 1.5 | 1.5 | 1.5 | 1.5 |
| Dried Thickness; µm | | 42 | 42 | 41 | 43 | 41 | 42 | 42 | 42 | 42 | 42 |
| 100-µm dev line width; µm | 20 | | | 88 | | | | | | | |
| | 40 | | | 107 | | | | 57 | | 101 | 105 |
| | 80 | 53 | 99 | 125 | NA | | 103 | 46 | 110 | 98 | 121 |
| | 160 | 95 | 107 | 145 | NA | | 108 | 94 | 123 | 106 | 136 |
| | 320 | 97 | 116 | | 30 | | 115 | 91 | 139 | 108 | NA |
| | 640 | 96 | 136 | | 79 | | | 94 | | 115 | |
| 150-µm dev space width; µm | 20 | | | 145 | | | | | | | |
| | 40 | | | 128 | | | | 186 | | 145 | 135 |
| | 80 | 204 | 142 | 109 | NA | | 140 | 205 | 130 | 145 | 117 |
| | 160 | 150 | 130 | NA | NA | | 132 | 154 | 116 | 132 | 99 |
| | 320 | 145 | 120 | | 201 | | 124 | 147 | 64 | 128 | NA |
| | 640 | 141 | NA | | 162 | | | 143 | | 119 | |
| Undercut; µm | 20 | | | 20 | | | | | | | |
| | 40 | | | 15 | | | -10 | | 25 | | 20 |
| | 80 | -10 | | 5 | | | 18 | -10 | NA | 20 | 22 |
| | 160 | 20 | | -35 | | | 18 | 25 | 5 | 20 | 15 |
| | 320 | 10 | | | -18 | | 10 | 20 | -15 | 5 | 5 |
| | 640 | 5 | | | 25 | | | 20 | | 8 | |
| Line Quality | 20 | | | Unacceptable | | | | | | | |
| | 40 | | | Unacceptable | | | | Unacceptable | | Unacceptable | Unacceptable |
| | 80 | Unacceptable | | | | | Unacceptable | Unacceptable | Unacceptable | | Unacceptable |
| | 160 | Unacceptable | | Unacceptable | | | Unacceptable | Unacceptable | Unacceptable | Unacceptable | |
| | 320 | | | | Unacceptable | | | Unacceptable | Unacceptable | | |
| | 640 | | | | Unacceptable | | | Unacceptable | Unacceptable | | |
| Judgement | 20 | | | | | | | | | | |
| | 40 | | | | | | | | | | |
| | 80 | | | | | | | | | | |
| | 160 | | Acceptable | | | | | | | | |
| | 320 | Acceptable | Acceptable | | | | Acceptable | | | Acceptable | |
| | 640 | Acceptable | | | | | | | | | |
| Overall decision (Total Judgement) | | Acceptable | Acceptable | Unacceptable | Unacceptable | Unacceptable | Marginal | Unacceptable | Unacceptable | Marginal | Unacceptable |

(Table V)

| | Amount of exposure, mJ/cm² | Application Example 1 | Application Example 2 | Comparative Example 1 | Comparative Example 2 | Comparative Example 3 | Comparative Example 4 | Comparative Example 5 | Comparative Example 6 | Comparative Example 7 | Comparative Example 8 |
|---|---|---|---|---|---|---|---|---|---|---|---|
| Upper dielectric layer | | Composition 5 | Composition 7 | Composition 1 | Composition 2 | Composition 3 | Composition 4 | Composition 5 | Composition 6 | Composition 7 | Composition 1 |
| Lower dielectric layer | | Composition 1 | Composition 1 | Composition 1 | Composition 2 | Composition 3 | Composition 4 | Composition 5 | Composition 6 | Composition 7 | Composition 7 |
| Transparency 365 nm @10 µm | | 68.6 | 68.6 | | | | | | | | 45.2 |
| Development time (2kgf) x TTC | | 2.5 | 2.5 | 2.5 | 2.5 | 2.5 | 2.5 | 2.5 | 2.5 | 2.5 | 2.5 |
| Dried Thickness; µm | | 42 | 42 | 41 | 43 | 41 | 42 | 42 | 42 | 42 | 42 |
| 100-µm dev line width; µm | 20 | | | NA | | | | | | | |
| | 40 | | | 108 | | | | | | | NA |
| | 80 | NA | NA | 123 | | | | | NA | 108 | 120 |
| | 160 | NA | 109 | 144 | | | 107 | NA | 119 | 102 | 131 |
| | 320 | 93 | 113 | | | | 113 | NA | 135 | 108 | 160 |
| | 640 | 96 | 130 | | | | | NA | | 114 | |
| 150-µm dev space width; µm | 20 | | | 186 | | | | | | | |
| | 40 | | | 132 | | | 243 | | 150 | | 138 |
| | 80 | NA | 146 | 116 | | | 145 | NA | 132 | 150 | 120 |
| | 160 | 152 | 132 | 36 | | | 135 | 235 | 120 | 135 | 104 |
| | 320 | 144 | 123 | | | | 125 | 152 | 77 | 131 | 56 |
| | 640 | 141 | NA | | 197 | | | 147 | | 122 | |
| Undercut; µm | 20 | | | | | | | | | | |
| | 40 | | | | | | | | | | |
| | 80 | | | | | | | | | | |
| | 160 | | | | | | | | | | |
| | 320 | | | | | | | | | | |
| | 640 | | | | | | | | | | |
| Line Quality | 20 | | | Unacceptable | | | | | | | |
| | 40 | | | Unacceptable | | | Unacceptable | | Unacceptable | | Unacceptable |
| | 80 | Unacceptable | | | Unacceptable | Unacceptable | Unacceptable | Unacceptable | Unacceptable | Unacceptable | Unacceptable |
| | 160 | Unacceptable | | | Unacceptable | Unacceptable | Unacceptable | Unacceptable | Unacceptable | | |
| | 320 | | | | Unacceptable | Unacceptable | | Unacceptable | | Unacceptable | |
| | 640 | | | | Unacceptable | Unacceptable | | Unacceptable | | Unacceptable | |
| Judgement | 20 | | | | | | | | | | |
| | 40 | | | | | | | | | | |
| | 80 | | | | | | | | | | |
| | 160 | | Acceptable | | | | | | Acceptable | | |
| | 320 | Acceptable | Acceptable | | | | Acceptable | | | | |
| | 640 | Acceptable | | | | | | | | | |
| Total Judgement | | Acceptable | Acceptable | Unacceptable | Unacceptable | Unacceptable | Marginal | Unacceptable | Marginal | Unacceptable | Unacceptable |

As seen from Table IV (when the developing time was 1.5 times with respect to TTC), in Application Examples 1 and 2, since the transmittance of the upper dielectric layer to light used in the pattern exposure was lower than the transmittance of the lower dielectric layer to light used in said pattern exposure, two conditions (an amount of exposure of 320 and 640 mJ/cm² in Application Example 1 and an amount of exposure of 160 and 320 mJ/cm² in Application Example 2) existed respectively as conditions allowing success (acceptability) for all the conditions. From this fact, it is understood that an intended pattern is precisely and easily realized by the present invention.

On the other hand, in each comparative example in which the transmittance of the upper dielectric layer to light used in the pattern exposure was the same as the transmittance of the lower dielectric layer to light used in said pattern exposure, the following results were obtained. In other words, in Comparative Examples 1, 2, 3, 5, 6, and 8, conditions that allowed success with respect to all the items could not be ascertained. In Comparative Example 4, the conditions allowing a success involved only an amount of exposure of 320 mJ/cm$^2$, and in Comparative Example 7, the conditions allowing success involved only an amount of exposure of 320 mJ/cm$^2$.

Also, as seen from Table V (when the developing time was 2.5 times with respect to TTC), in Application Examples 1 and 2, since the transmittance of the upper dielectric layer to light used in the pattern exposure was lower than the transmittance of the lower dielectric layer to light used in said pattern exposure, two conditions (an amount of exposure of 320 and 640 mJ/cm$^2$ in Application Example 1 and an amount of exposure of 160 and 320 mJ/cm$^2$ in Application Example 2) existed respectively as conditions allowing success for all the items. From this fact, it is understood that an intended pattern is precisely and easily realized by the present invention.

In each comparative example in which the transmittance of the upper dielectric layer for light used in the pattern exposure was the same as the transmittance of the lower dielectric layer for light used in the pattern exposure, the following results were obtained. In other words, in Comparative Examples 1, 2, 3, 5, 7, and 8, conditions that allowed success with respect to all the items could not be ascertained. In Comparative Example 4, the conditions allowing success involved only an amount of exposure of 320 mJ/cm$^2$, and in Comparative Example 6, the conditions allowing success included only an amount of exposure of 160 mJ/cm$^2$.

From these results, when the developing time was 1.5 times and 2.5 times with respect to TTC, two or more conditions wherein the overall result was a success were confirmed only in Application Examples 1 and 2. This means that even if at least one of the exposure conditions and the developing conditions is changed, a desired pattern is formed in Application Examples 1 and 2. On the contrary, it means that if one of the exposure conditions and the developing conditions is changed, a desired pattern is not formed in each comparative example. Therefore, if the dielectric of the present invention is used, the exposure conditions or developing conditions can be changed, so that it is assured that even if the manufacturing conditions are changed for any reason, the yield of the product is not lowered.

**Claims**

1. A dielectric comprising an upper dielectric layer formed on a lower dielectric layer, wherein the lower dielectric layer is comprised of a first photosensitive composition comprising a first glass powder, and the upper dielectric layer is comprised of a second photosensitive composition comprising a second glass powder, and wherein the transmittance of the upper dielectric layer to light used to create a desired pattern of exposure is lower than the transmittance of the lower dielectric layer to said light.

2. The dielectric of claim 1, wherein the transmittance of said second glass powder used in said upper dielectric layer is lower than the transmittance of said first glass powder used in said lower dielectric layer.

3. The dielectric of claim 1 or claim 2, wherein said lower dielectric layer consists essentially of glass as the only inorganic component.

4. The dielectric of any preceding claim, wherein said upper dielectric layer consists essentially of glass as the only inorganic component.

5. The dielectric of any preceding claim, wherein the wavelength of said light is in the range of 350-400 nm.

6. The dielectric of any preceding claim, wherein said first glass powder and said second glass powder are bismuth-containing glass powders.

7. The dielectric of claim 6, wherein said first glass powder is selected from a Bi-Al-B-Si-Zn-Ba containing glass powder or a Bi-Al-B-Si-Zn-Ca containing glass powder.

8. The dielectric of claim 7, wherein the total content of said Bi-Al-B-Si-Zn-Ba containing glass powder or said Bi-Al-B-Si-Zn-Ca containing glass powder is in the range of 40 to 100 weight percent, with respect to the total glass powder content of the lower dielectric layer.

9. The dielectric of claim 6, wherein the second glass powder is selected from a Bi-Al-B-Si-Zn-Ba containing glass powder or Bi-Al-B-Si-Zn-Ca containing glass powder.

10. The dielectric of claim 9, wherein the total content of said Bi-Al-B-Si-Zn-Ba containing glass powder or said Bi-Al-B-Si-Zn-Ca glass powder is in the range of 40 to 100 weight percent, with respect to the total glass powder content of the upper dielectric layer.

11. The dielectric of claim 9 or claim 10, wherein said second glass powder further comprises at least one element selected from Fe, V, Ti, Cu, and Co.

12. The dielectric of any preceding claim, wherein the transmittance of light of said second glass powder is 30 percent or more, but less than 60 percent; and the transmittance of light of the first glass powder is 60 percent or more.

13. The dielectric of any preceding claim, wherein said lower dielectric layer and said upper dielectric layer are essentially lead-free.

14. The dielectric of any preceding claim, wherein said lower dielectric layer and said upper dielectric layer are essentially free of filler.

15. The dielectric of any preceding claim, wherein said lower dielectric layer and said upper dielectric layer are essentially free of alkali compounds.

16. A display equipped with the dielectric of any preceding claim.

17. A method for manufacturing a dielectric as defined in any one of claims 1 to 16, comprising the following steps:

   providing a lower photosensitive dielectric composition and an upper photosensitive dielectric composition each comprising a glass powder, monomer, initiator, resin binder, and organic solvent;
   providing a substrate;
   coating said lower photosensitive dielectric composition on said substrate;
   drying said lower photosensitive dielectric composition to form a lower dielectric layer;
   coating said upper photosensitive dielectric composition on said lower dielectric layer;
   drying said upper photosensitive dielectric composition to form an upper dielectric layer;
   exposing a prescribed pattern on said lower dielectric layer and said upper dielectric layer;
   developing the exposed layers to form developed layers; firing the developed layers; and

   wherein said upper dielectric layer has a lower transmittance of light used in a pattern exposure compared to that of said lower dielectric layer.

**FIG. 1**

**FIG. 2**

24

22

18

20

## FIG. 3

38

36

34

30

32

46

44

40

42

## FIG. 4

First Step

Coating of a lower dielectric
composition on a substrate — 102

↓

Second Step

Formation of a lower
dielectric layer by drying — 104

↓

Third Step

Coating of an upper dielectric composition
on the lower dielectric composition — 106

↓

Fourth Step

Formation of an upper
dielectric layer by drying — 108

↓

Fifth Step

Exposure — 110

↓

Sixth Step

Developing — 112

↓

Seventh Step

Sintering — 114

# FIG. 5

(A)

206
204
202

(B)

208
202

(C)

206
209
208
202

(D)

210
208
202

(E)

214
212
210
208 } 216
202

(F)

218
220
202

(G)

222
202

# FIG. 6

**FIG. 7**

**FIG. 8**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP HEI8199650811 A
- JP 2004318116 A
- US 3380381 A
- US 2927022 A
- US 5032490 A
- US 2760863 A
- US 2850445 A
- US 2875047 A
- US 3097096 A
- US 3074974 A
- US 3097097 A
- US 3145104 A
- US 3427161 A
- US 3479185 A
- US 3549367 A
- US 4162162 A
- US 5132490 A